**Europäisches Patentamt**

**European Patent Office**

**Office européen des brevets**

(19)

(11) Publication number: **0 204 451**
B1

# EUROPEAN PATENT SPECIFICATION

(12)

(45) Date of publication of the patent specification: **13.09.89**

(51) Int. Cl.⁴: **H 05 K  13/00,** H 05 K  13/04, H 05 K  13/08

(21) Application number: **86303711.5**

(22) Date of filling: **15.05.86**

(54) Circuit assembly system.

(30) Priority: **16.05.85 US 734964**

(43) Date of publication of application: **10.12.86 Bulletin 86/50**

(45) Publication of the grant of the patent: **13.09.89 Bulletin 89/37**

(84) Designated Contracting States: **BE CH DE FR GB IT LI NL SE**

(56) References cited:
EP-A-0 109 825
US-A-4 125 136
US-A-4 218 817
US-A-4 356 619
US-A-4 557 043

(73) Proprietor: **Holcomb, Gregory W., 12 Viento, Irvine California 92714 (US)**

(72) Inventor: **Holcomb, Gregory W., 12 Viento, Irvine California 92714 (US)**

(74) Representative: **Pears, David Ashley, REDDIE & GROSE 16 Theobalds Road, London WC1X 8PL (GB)**

## Description

The present invention pertains to systems for assembly of electrical components with printed circuit boards and relates more specifically to apparatus for active clinching of component leads, as set forth in the introductory part of claim 1.

Robotic equipment is commonly employed in many industrial applications. In one important application, robotic equipment inserts electronic components into predetermined locations on printed circuit boards. Commonly, the boards are passed along an assembly line on a conveyor. At separate stations along the line, insertion machines insert components of the same type. The robotic equipment of the prior art are generally unable to handle more than one size or shape of components without changing or modifying the machine to accommodate the different part. Thus, a different machine station may typically be employed to insert each different sized or shaped component. This, of course, greatly increases the capital equipment cost of the product insertion line, and increases the physical space needed to house and support the assembly line. For components which have nonstandard shapes and sizes and/or for which small quantities are used in the circuit hand labour is typically employed to finish the insertion process for each board, thus further reducing the speed and efficiency by which the boards may be assembled.

Numerous mechanisms are known for automatically clinching component leads which have been inserted through apertures in printed circuit boards. Passive systems are known which move the part so that the leads strike a bending surface, to bend the leads in a manner analogous to the manner in which a paper stapler operates (EP-A-0 109 825). Active clinchers hold the electrical component stationery, but move a die to deflect the leads in a predetermined direction. The dies employed are often jaw-like members which open and close to bend the leads. Typically, the die is particularly adapted to clinching the leads of a predetermined part type, e.g., for a dual inline integrated circuit package, and to bend or clinch all the leads aligned in a row.

A known apparatus in accordance with the introductory part of claim 1 is disclosed in US-4 135 558 for example.

In large part, the known clincher systems are expensive to manufacture and maintain, and are specialized systems for performing a single predetermined function.

With a view to overcoming these problems, the apparatus according to the invention is characterized in the manner set out in claim 1.

Apparatus for automatic insertion of electrical components into printed circuit boards is disclosed in the preferred embodiment. The apparatus comprises a component presentation robot for delivering a predetermined component to a presentation station, and a component insertion robot for gripping the presented component at the presentation stage, and inserting the component into the circuit board at an insertion station.

The presentation robot selects a predetermined electrical component type from one or more component storage areas, and presents the component to a presentation station, which also serves as a lead straightening and cutting station. This station comprises a pair of plates through which an opening pattern of funnel shaped openings have been formed. The lower plate is movable laterally with respect to the upper plate to provide a lead clamping and cutting function. The component presentation robot is adapted to deliver the selected component to the presentation station. The robot then inserts the component leads into corresponding opening patterns formed in the plates and oscillates the component body through a series of predetermined movements, repetitively exercising the leads in relation to the component body. The oscillatory movement is adapted to cause the lead positions to assume an averaged, straightened position.

Once the predetermined series of lead straightening movements have been carried out, the presentation robot releases the component, and the lower plate is shifted slightly with respect to the upper plate to clamp the component leads. The component insertion robot then grips the body of the component and a lead cutting operation may be performed, wherein the lower plate is shifted through a shearing movement to shear the leads extending below the first plate. The component insertion robot then inserts the component at a predetermined position on the printed circuit board.

In accordance with the invention a programmable clinching system for clinching leads of inserted components. The clinching of the preferred embodiment comprises a retractable clinching element mounted on a motor driven carriage assembly for passing the clinching element through a predetermined path of travel adjacent the lower surface of the printed circuit board. The clincher element operates in combination with the component insertion robot so that, as each component is inserted into the board, the clincher element is passed beneath the inserted component in a clinching movement to clinch one or more of the component leads and thereby secure the inserted component in position.

The cycle comprising component presentation, lead straightening and cutting, board insertion, and lead clinching is then repeated until all components have been inserted in the board. A conveyor system is employed to transport the fully inserted board away from the insertion station, and to transport an empty board to the insertion station.

## Brief Description of the Drawings

The various, features and advantages of the disclosed invention will be readily appreciated by those skilled in the art from the following detailed disclosure when read in conjunction with the drawings, wherein:

Fig. 1 is a perspective view illustrating a robotic system employing the preferred embodiment.

Fig. 2 is a top plan view of an embodiment of the invention, comprising a component lead clinching apparatus.

Fig. 3 is a top plan view of the apparatus of Fig. 2, with the top plate of the work surface displaced in accordance with the invention to increase the effective board area which may be accessed by the clincher tool.

Fig. 4 is a top plan view illustrating the apparatus shown in Fig. 2 without the top plate to show the clincher tool and x - y drive mechanisms.

Fig. 5 is a front view of the apparatus of Fig. 4, in the direction of arrows 5 - 5 in Fig. 4.

Fig. 6 is a cross-sectional view of the apparatus of Fig. 4 taken along line 6 - 6 in Fig. 4.

Fig. 7 is à cross-sectional view of the apparatus of Fig. 4 taken along line 7 - 7 in Fig. 4.

Fig. 8 is a cross-sectional view of the apparatus of Fig. 4, taken along line 8 - 8 in Fig. 4.

Fig. 9 is a cross-sectional view of the clincher cylinder assembly, taken along line 9 - 9 of Fig. 6.

Fig. 10 is a side view of a printed circuit board with inserted component in position on the top plate of the apparatus, illustrating the clincher cylinder assembly clinching one lead of the component.

Fig. 11 is a bottom view of the printed circuit board of Fig. 10, showing the clincher rod in cross-section.

Fig. 12 is a perspective view of a second embodiment of a component insertion system including apparatus for component lead straightening, component insertion, and lead clinching.

Fig. 13 is a simplified top view of the second embodiment.

Fig. 14 is a simplified top view illustrative of the conveyor system employed in the second embodiment, showing the relationship of the insertion station and the lead straightening and cutting station.

Fig. 15 is a cross-sectional view of the side rail and conveyor chain taken through line 15 - 15 of Fig. 14.

Fig. 16 is a cross-sectional view, taken along line 16 - 16 of Fig. 14, illustrative of the clamping means for securing the position of the printed circuit board.

Fig. 17 is a cross-sectional view, taken along line 17 - 17 of Fig. 14, showing a printed circuit board on the conveyor in relation to the clamping means.

Fig. 18 is a cross-sectional view, taken along line 18 - 18 of Fig. 14, illustrating the conveyor drive sprocket and motor.

Fig. 19 is a cross-sectional view, taken along line 19 - 19 of Fig. 14, illustrating the lead straightener and cutting apparatus.

Fig. 20 is a partial cross-sectional view, taken along lines 20 - 20 of Fig. 19, showing the upper and lower lead straightening and cutting plates.

Fig. 21 is a top partial broken-away view of the lead straightening and cutting plates.

Fig. 22 is a cross-sectional view, taken along line 22 - 22 of Fig. 21, illustrating a pair of lead funnels defined in the lead straightening and cutting plates.

Fig. 23 is a perspective view of the robot arm end effector employed to pick up an electrical component and insert the component leads into the funnels formed in the lead straightening and cutting plates.

Fig. 24 is a block diagram of the lead clincher system.

Fig. 25 is a block diagram of the component insertion system depicted in Fig. 12.

Figs. 26(a) - (c) depict a tube feeder and the grasping of components from the tube feeder by the presentation robot.

## Detailed Description of the Preferred Embodiment

The present invention comprises a novel robotic system for insertion of electrical components into printed circuit boards. The following description of the preferred embodiment is provided to enable any person skilled in the art to make and use the invention. Various modifications to the disclosed embodiment will be readily apparent. The invention is not intended to be limited to the embodiment shown, but is to be accorded the widest scope consistent with the principles and novel features of the invention.

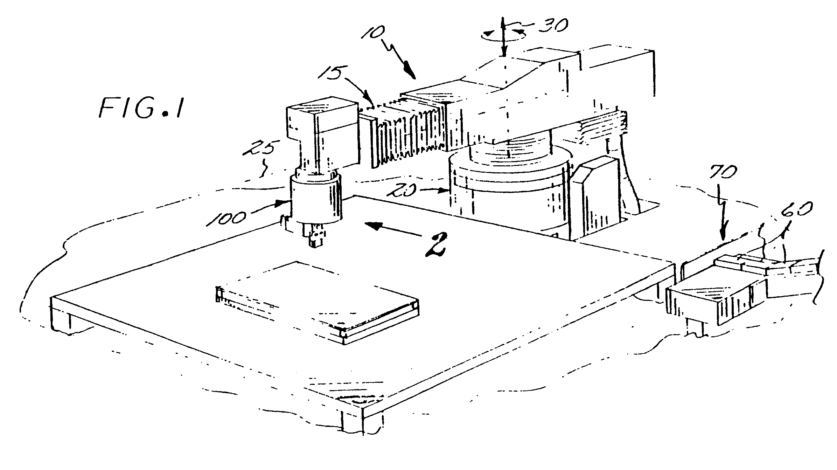

Referring now to Fig. 1, a perspective view is shown of components of a robotic system in accordance with the present invention. In this embodiment, robot 10 comprises a model RT-3000 robot marketed by Seiko Instruments USA Inc. This robot is a programmable, 4 axis DC servo robot with nominal positional repeatability of ± 0.025mm (± .001 inches). Robot arm 15 extends from the robot body 20 along axis 25. The arm is selectively extensible and retractable along axis 25, and is rotatable about the center axis 30 of the robot body 20. The body 20 is also selectively extensible and retractable along axis 30 to raise and lower the arm 15.

The robot 10 also includes a central controller and a keyboard interface (not illustrated in Fig. 1) which allows the system operator to interface with the central controller. As is well known to those skilled in the art, the system controller is programmed to carry out predetermined movements and operational sequences. Thus, the controller is programmed to relate the known position of the leads of the component held at a pickup station to the known location on the circuit board at which the component is to be inserted.

The end effector is attached to the extensible end of arm 15. As is well known to those skilled in the art, the end effector is employed to interface with the components to be handled by the robotic system. The components 60 are delivered to a pick-up station 70. The robot controller is programmed to cause the robot arm to move the end effector to above the pick-up station 70, and then to lower the end effector so as to grip the next component in the conveyor line.

The pick-up station employs a pneumatically operated component lead clamping vise 60, which clamps the component leads to fix the component at the predetermined pick-up point.

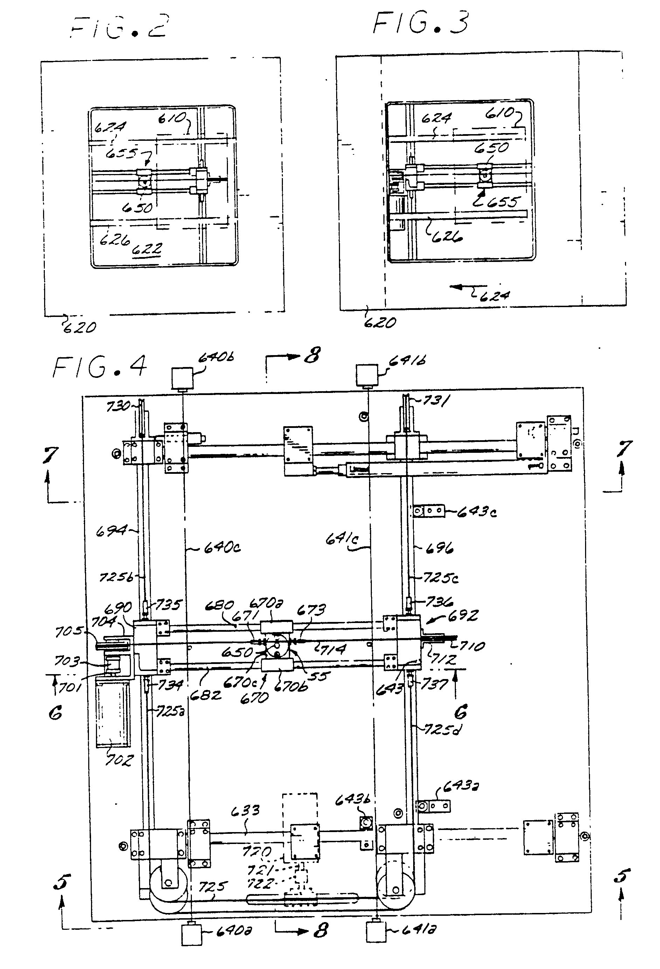

Illustrating another aspect of the invention, Figs. 2 and 3 are top plan views of an apparatus which is advantageously employed to clinch the leads of components which have been inserted into a printed circuit board, for example, by the above-described component insertion robot. In this embodiment, the apparatus comprises a table surface 620 having a large aperture 622 formed therein. A printed circuit board 610 (shown in phantom) is suspended over the aperture 622 by attachment to elongated support ribs 624, 626. The ribs 624, 626 are preferably adjustable in their position over the aperture 622 so as to accommodate variously sized circuit boards.

The surface 620 is translatable along the axis of arrow 624 shown in Fig. 3. As will be described in more detail below, this embodiment comprises means for translating the table surface 20 between the respective positions illustrated in Figs. 2 and 3.

With at least one electrical component, inserted in the circuit board 610 and gripped by the insertion robot, a retractable clincher element 650 mounted for translational movement throughout a plane which is parallel to and beneath the printed circuit board travels through a controlled series of predetermined movements to selectively contact and clinch individual leads of the component.

As used herein, "clinching" a component lead refers to the bending of a component lead away from the nominal lead position, perpendicular to the printed circuit board, to a bent or clinched location adjacent the printed circuit board.

The clincher element movement is controlled by a processor which is programmed with information defining the desired path the clincher element is to travel. Thus, the system user is able to adapt the system to the clinching requirements for virtually any circuit board and any type of inserted component.

To achieve the capability for controllable movement, the clincher element 650 is mounted in an assembly 655, which in turn is carried by an upper carriage assembly 670 supported for lateral movement on a pair of lateral rods 680, 682. The ends of the lateral rods 680, 682 are in turn mounted in first and second lower carriage assemblies 690, 692, respectively, carried for longitudinal movement on opposed longitudinal rods 694, 696.

Lateral drive means are provided for driving the upper carriage assembly 670 to traverse the lateral extent of the lateral rods 680, 682. Similarly, longitudinal drive means are provided for driving the lower carriage assemblies 690, 692, which carry the lateral rods 680, 682 and upper carriage assembly 670, to traverse the longitudinal extent of rods 694, 696.

The lateral drive means comprises the upper stage stepper motor 702, mounted to carriage 690 by bracket 704. Motor 702 comprises a stepper motor, model M063, marketed by the Superior Electric Company. As shown in Fig. 4, the motor 702 is coupled through motor coupler 703 to the drive shaft of drive pulley 705. Pulley 705 is mounted on bracket 704 for rotation about an axis in line with the axis of the motor 702.

Idler pulley 710 is carried by pulley bracket 712 mounted on carriage assembly 692. Idler pulley 710 and drive pulley 705 are mounted for rotation about respective pulley axes which are substantially parallel. A stainless steel cable 714 having a diameter of 1.65 mm (.065 inches) is reeved around the drive pulley 705 and the idler pulley 710, and its ends are secured in cable fixtures 671, 673, which are respectively secured in opposite sides of the upper carriage 670.

Rotation movement of the motor shaft causes the drive pulley 705 to rotate. Rotational movement of the drive pulley 705 imparts a driving force to the cable 714, resulting in movement of the upper carriage 70 along the rods 680, 682. So long as there is no cable slippage, the extent of the movement of carriage 70 is precisely related to the rotation of the motor shaft. Thus, each angular movement step by the motor shaft can be translated to a translational movement by the carriage 670. In the disclosed embodiment, each step of the motor 702 results in the translation by 0.025 mm (.001 inch) of carriage 70.

The carriage 670 comprises a pair of ball bushing members 670a, 670b and a center carriage bracket 670c fixedly coupling the bushing members and supporting the clinch ball assembly 655. In this embodiment, ball bushing members 670a, 670b comprise Thompson ball bushings, model Super-6, which are mounted on rods 680, 682, which have a diameter of 9.5 mm (.375 inches). The ball bushings 670a, 760b and the rods 680, 682 are adapted to provide extremely low friction, facilitating linear travel of the carriage along the rods 680, 682.

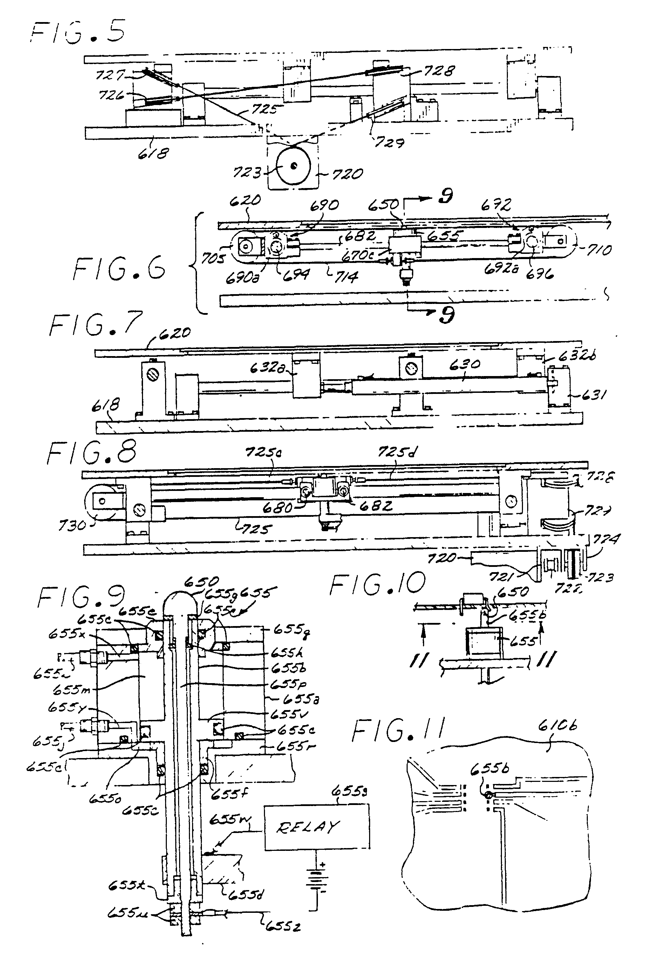

With reference to Figs. 4 - 6 and 8, the longitudinal drive means comprises the lower stage stepper motor 723, secured to lower surface 618 by a mounting bracket 724, as shown in Fig. 9. In the disclosed embodiment, motor 620 comprises a model M093 stepper motor marketed by the Superior Electric Company. The motor shaft 721 is coupled to drive pulley 723 by coupler 722. Drive pulley 723 is rotatably mounted for rotation about the motor shaft axis.

As illustrated in Figs. 4 and 5, idler pulleys 726, 727, 728 and 729 are mounted for rotational movement adjacent the motor 720 and ends of longitudinal rods 694 and 696. Idler pulleys 730 and 731 are mounted for rotational movement adjacent the other end of the rods 690 and 692.

Cable 725 is reeved about the drive pulley 723 and about upper pulley 727, and end 725a is secured to the carriage 90 by cable bracket 734. On the side of carriage 690 opposite from bracket 735, end 725b of cable 725 is secured to carriage 90 by cable bracket 735.

Cable 725 is reeved about idler pulley 729 from drive pulley 723, and is passed to the other end of rod 692 to idler pulley 731. The cable 725 is reeved about pulley 731, and end 725c is secured to carriage 692 by cable bracket 736. On the side of carriage 692, opposite from bracket 736, end 725d of cable 725 is secured by cable bracket 737. From bracket 737, the cable 725 is reeved about idler pulley 728, and passes diagonally downwardly to pulley 726. From pulley 726, the cable 725 passes to the opposite end of rod 690, where it is reeved about pulley 730 and passed to cable bracket 735.

The lower carriage assemblies 690, 692 respectively comprise bushing members 690a, 692a, which respectively encircle longitudinal rods 694, 696. In this embodiment, ball bushing members 690a, 692a comprise Thompson ball bushings, model Super-12, and the rod 694, 696 have a diameter of 19 mm (.75 inches). The ball bushings 690a, 692a and the rods 694, 696 are adapted to provide extremely low friction, facilitating linear travel of carriages 690, 692 along the longitudinal extent of the rods 694, 696.

The cable and pulley system shown in Figs. 4 and 5 thus provides a means of converting rotational movement of the motor shaft 721 into translational cable movement. Both carriages 690 and 692 are driven by the cable 725, in response to rotations of the motor shaft 721. As with the lateral drive system, the longitudinal movement of the carriages 690 and 692 is precisely related to the rotational shaft movement of motor 720, with each step of motor 720 resulting in 0.025 mm (.001 inches) of longitudinal movement of the carriages 690, 692 along the rods 694, 696. Thus, by controlling motor 720, clincher ball assembly 655 can be longitudinally positioned.

Stepper motors 702 and 720 are controlled by motor drivers, which receive digital drive signals from a system controller. The system controller generates appropriate drive signals to cause the stepper motors to drive the clincher element assembly through a desired path of travel and/or to a desired position. In the disclosed embodiment, the clinching element is driven at velocities up to 2.5 m (100 inches) per second.

Referring now to Fig. 9, the clincher assembly 655 comprises a double-acting air cylinder assembly, mounted to the carriage 670. Such air cylinders are commercially available, and in the disclosed embodiment, a Fabco-Air model F-7-X, with a 19 mm (3/4 inch) bore and 16 mm (5/8 inch) stroke, is employed.

The air cylinder assembly 655 comprises cylinder wall 655a and hollow outer piston rod assembly 655b. The outer piston rod 655b is integrally formed with a piston 655v. A pair of ports 655x, 655y are formed through the wall of the cylinder 655a to communicate with opposing chambers 655m, 655o defined by cylinder 655a, bushings 655e, 655f and piston 655v.

The air cylinder assembly is fitted with O ring seals 655c at appropriate locations to prevent air leaks. A pair of air lines 655i and 655j communicate with chamber 655m and 655o, respectively through the ports 655x, 655y, and are respectively coupled to sources of air pressure or vacuum. The piston rod assembly 655b is forced upwardly or downwardly in dependence upon the relative pressurization of chambers 655m and 655o.

The stroke of the piston rod assembly is nominally five-eighth inches in the disclosed embodiment. Thus, by selective pressurization of the respective chambers, the piston rod assembly, to which the clinching element 650 is attached, is forced either into the upward state for clinching or the downward retracted state. In the extended clinching position, the clinching element is directly adjacent the lower surface of the circuit board, almost in contact with the surface. In the retracted position, the clinching element 605 is disposed well beneath the lower surface of the board so as not to contact downwardly extending leads.

The clinching element 650 comprises a rounded ball element, having as nominal diameter of 8 mm (5/16 inches), and is secured to inner rod 655p by threaded securing means or the like. The inner rod member 655p is biased in a concentric relationship with outer rod 655b by elastic centering ring 655h and plastic insulating bushing 655t. A pair of plastic insulating bushings 655e and 655f are employed to locate the outer piston rod assembly 655b with respect to the cylinder housing members 655q and 655r.

One aspect of the invention is the provision of a tactile sensing means for detecting whether the clinch operation has been successfully performed. The sensor comprises means for sensing for electrical continuity between the outer piston 655b and inner rod member 655p. Due the elasticity of the centering ring 655h, the inner rod may be deflected from its normal concentric position in relation to the outer rod member 655b. When it is deflected, for example, by the deflection force resulting from the collision of a component lead with clinching element 650, electrical continuity is achieved between the inner rod 655p and the end outer member 655b in the region between plastic insulating washer 655g and the elastic centering ring 655h.

A monitoring circuit, shown generally in Fig. 9 as circuit 655s, is coupled between the outer rod 655b and the inner rod 655p by wires 655r and 655z, respectively. The clinch system controller monitors the circuit output.

Plastic insulating bushing 655t secures the lower ends of the respective inner and outer rod members in electrical isolation in their concentric relationship. Wire 655z is secured to the inner rod member by a pair of lock nuts 655u. The wires 655r, 655z and the two air lines 655i and 655j are brought away from the air cylinder assembly 655 as an umbilical line, which is trailed or dragged behind the air cylinder as it is moved about by the carriage assemblies.

Referring now to Fig. 10, the air cylinder assembly 655 is shown with the clinching element in the extended or clinch state in contact with the lead of an inserted electrical component. The electrical lead exerts a deflection force on the ball 655, which deflects the inner rod 655p with respect to the outer rod 655b so as to achieve electrical continuity between the two members, resulting in a clinching signal from the monitoring circuit. Of course, the clinch ball 655 also exerts a clinch force on the lead, such that the lead is clinched or bent along the underside of 610b of the board 610.

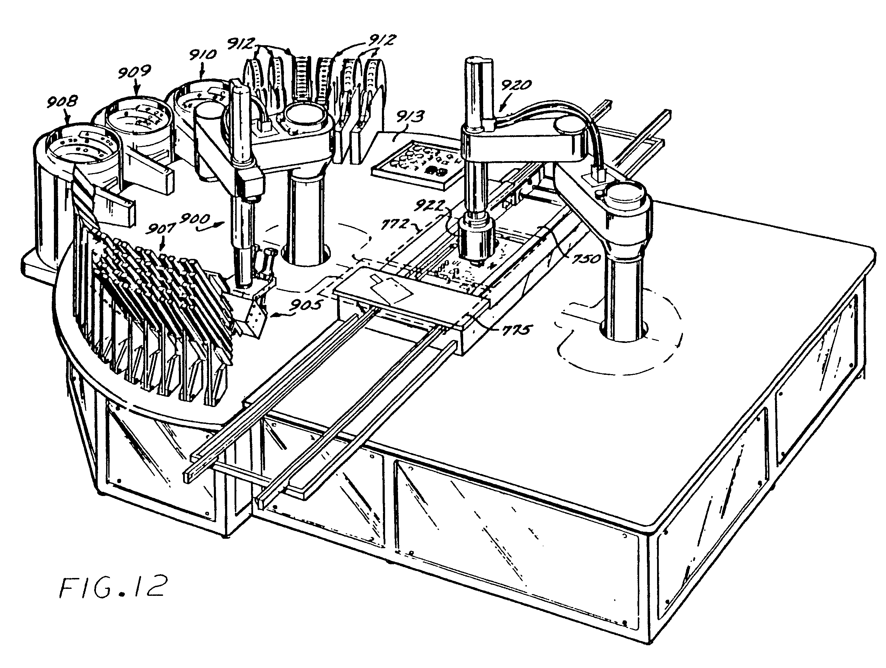

Fig. 11 is a cross-sectional view taken along line 11 - 11 of Fig. 10 illustrating the relative position 610b of the clinch ball in relation to the leads of the electrical component and the printed conductors on the underside of the printed circuit board 610.

Fig. 7 illustrates one of the two air cylinders which serves to position the table surface 620 in one of the positions shown in Fig. 2 or Fig. 3. The upper table surface 620 is supported by conventional means (not shown), such as a slide mechanism, for lateral movement with respect to lower table surface 618. Bracket 631 is affixed to table 618 and supports one end of air cylinder 630. Bracket 632a is affixed to the underside of table surface 620, and supports the other end of air cylinder 630.

Actuation of the air cylinder 630 exerts a force tending to separate the bracket 632a and the bracket 631, causing the upper surface to slide laterally toward the position illustrated in Fig. 3. A second air cylinder 633, shown in Fig. 4, is configured to provide an oppositely directed force to slide the surface 620 toward the position shown in Fig. 2. Alternatively, a single double-acting air cylinder may be employed to slide the table surface between the two positions illustrated in Figs. 2 and 3.

The provision of means to translate the table surface 620, which carries the circuit board, with respect to the clinch element drive system, increases the maximum board size which may be accommodated by the clinch system. A particular board can be disposed at one of the two surface 620 positions, and the components inserted and clinched in the portion of the board accessible to the clinch element. The surface 620 with the board may then be shifted to the second position, and components inserted and clinched in the portion of the board now available to the clinch element.

A plurality of position sensors are employed to accurately determine a reference position for the clincher element 650, for example, in relation to the insertion robot system, and provide end-of-travel information to prevent the clincher element from accidental out-of-limit contact with other structural elements.

Left and right upper stage travel limit sensors 640, 641 comprise photoelectric sensors. The sensors comprise LED light source 640a, 641a and photodetectors 640b, 641b. The sources project respective light beams along axis 640c, 641c which are detected by the respective detectors 640b, 641b. Lateral movement of upper carriage assembly 670 so as to interrupt the light beam on either side causes an out-of-limit signal to be generated by the appropriate detector 604b or 641b. In the disclosed embodiment, the photoelectric sensors comprise two miniature LED pairs, models L33 and P33 marketed by the Skan-A-Matic Corporation.

The lower stage travel limit sensors comprise Hall effect sensors. A magnet 643 is mounted to lower carriage 692. Hall effect sensors 643a, 643b are mounted to the lower table surface 618 in appropriate locations relating to the upper and lower end-of-travel limits for the lower carriage 692. As the carriage 692 is passed in close proximity to the one of the Hall effect sensors, its magnetic field triggers the sensor. Sensor 643c is the "home" or reference position sensor. This position is the reference or start position to which the clinch element is typically set at the commencement of clinch operations for each board. The controller references the various clinch element movements from the "home" position.

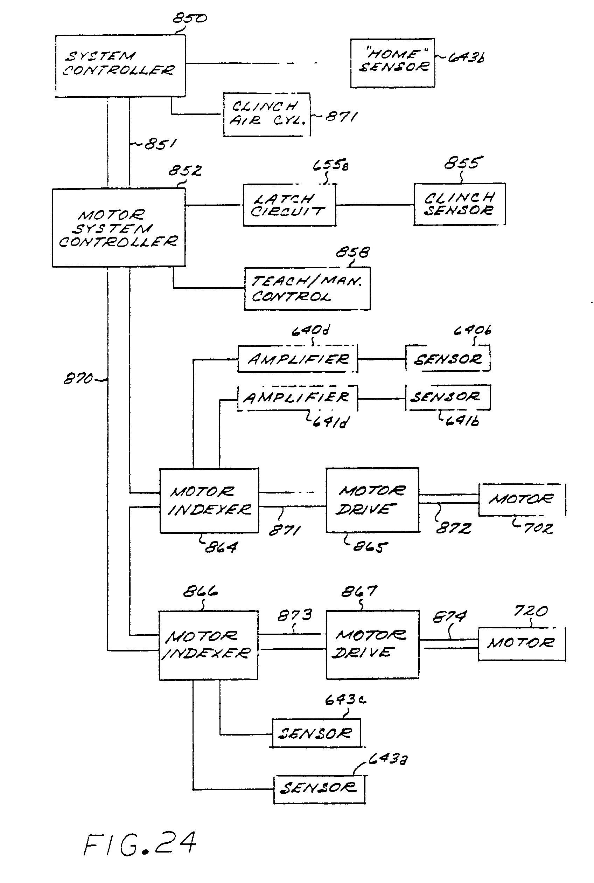

Fig. 24 is a control block diagram illustrative of the clincher control system. A system controller 850, which comprises a personal computer system such as the IBM PC personal computer with memory display and keyboard peripherals, provides overall system control.

The system controller is coupled to interface device 852 by an RS232 interface bus 851. For the disclosed embodiment, the interface device is part of a motor control and drive system for the Superior Electric motors 702, 720 described above. The interface device 852 comprises the Modulynx system controller card, model number 10D 009 marketed by the Superior Electric Company.

The interface device 852 is coupled by 50 pin bus 870 to the upper and lower stage drive systems. The upper stage drive system comprises indexer circuit 864, the Modulynx indexer card model number IMD 128 and driver card 865, the Modulynx driver card model number DRD 002A. Both devices 864, 865 are marketed by the Superior Electric Company. The driver card 865 drives the stepper motor 702.

The upper stage travel limit sensors 640b, 641b are coupled through the respective amplifiers 640d, 641d to the indexer card 864. An out-of-limit signal from one of the sensors provides an interrupt signal stopping the motor 702 from further operation in the out-of-limit direction. This interrupt provides a "soft stop," i. e., the system controller may drive the clincher assembly 655 up to a travel limit, where the motor is stopped, and then drive the assembly 655 away from the limit.

The lower drive system comprises index card 866, also a Modulynx index card model IMD 128, and motor driver 867, a Modulynx driver card, model DRD 003. Bus 873 couples the index card 866 to motor driver 867. Bus 874 couples the motor driver 874 to motor 720.

The lower stage travel limit sensors 643a,b are coupled to indexer card 866. An out-of-limit signal from one of the signals provices an interrupt signal providing a "soft stop" which stops the motor 720 from further operation in the respective out-of-limit direction.

The "home" position sensors 643c is coupled to the system controller 850. The system controller 850 also controls the operation of air valves (not shown) controlling the operation of the air cylinder of the clinch assembly 650. The air valves and air cylinder are indicated in Fig. 24 as block 871.

The interface device 852 is further coupled to the clinch tactile sensor circuit 855 through latch circuit 855, comprising a relay, and to the teaching and manual control pendant 858. The sensor 855 provides a feedback signal to the controller 850 indicating whether a desired clinch has occurred.

The pendant 858 enables manual operation of the clinch system and, in combination with an operator keyboard comprising the controller 850, provides a means of manually teaching or entering a desired clinch path. The pendant includes four separate switches for +X, -X, +Y, -Y movement, a "clinch up" switch for extending the clinch element 650 into the extended clinch state, a "step/jog" switch to select signal step or jog movement modes, a emergency stop switch and a switch for selecting between manual or processor control.

In a typical manual teaching sequence, an identifying number for the component to be clinched is entered into the controller 850 via the keyboard. Then the operator by manually manipulating the +X, -X, +Y, -Y controls appropriately, moves the clinch element 650 to the appropriate start position required to initiate the desired clinch path. The start position of the clinch element for this component, in relation to the "home" position, is then stored in the memory of the controller 850. The controller 850 is adapted to keep track of the position of the clinch element in relation to the system "home" position by monitoring the number of motor steps and their direction from the "home" position.

If, during the next move, it is desired to clinch a lead of the component, the operator activates the "clinch up" control on the pendant 858. The appropriate movement controls (+X, -X, +Y, -Y) are then activated to execute the desired clinch path. If the leads are not be clinched during this sequence of moves, the "clinch up" switch is not activated.

In the next step of the teach sequence, the final position of the clinch head and clinch element (up or down) are stored in the controller memory.

The preceding two steps are then repeated to perform all desired clinching movements for the particular component. The entire sequence is then repeated for each of the components on the board requiring clinching.

Once the teaching mode is completed for the components inserted on a particular board, the processor 850 will have been provided, for each component, with a component identification number, a clinch path start position, and a plurality of successive intermediate clinch element positions, each with corresponding clinch element positions (extended or retracted). These data enable the processor to automatically repeat the clinch element path pattern for each component in a "run" operation.

In a simple run operation, the operator may manually enter into the processor 850 the identification number of the component to be clinched, and then signal to the processor to execute the stored clinch cycle for that component. Under control of the processor 850, the previously stored or "taught" clinch path of the clinch element will be executed while the element 650 moves up and down as required to clinch the desired leads of the component.

The clinch system will typically be operated in cooperation with a component insertion robot, as described above. As each component is inserted into the board, the clinching system will be operated to clinch one or more of the leads of the inserted component. Typically, the entire insertion and clinch operation will be coordinated and executed automatically under control of the processor 850. Moreover, it is expected that the system will be data driven by positional data and cycle instructions provided as a result of computer-aided design techniques, rather than by manually teaching each of the movements of the cycle.

Referring now to Fig. 12, a perspective view is shown of an embodiment of a component insertion system embodying the invention. In general, the component insertion system comprises a component presentation module which includes a presentation robot 900 for selecting a component from one of a plurality of component feeder devices and providing the selected component to a presentation station for lead straightening and cutting. A component insertion module includes an insertion robot, which retrieves the component at the presentation station and inserts it into the printed circuit board. The component insertion module further comprises a clinching system as described above for clinching the leads of the inserted component.

The component presentation module comprises a presentation robot 900 and one or more component feeder devices. Thus, for example, the component presentation module may include tube or stick feeders 907, vibratory bowl feeders 908 - 910, tape feeders 912, and tray feeders 913. The feeder devices per se are well known and need not be described in further detail.

The component presentation robot 900 is adapted to pick up a component from one of the feeder devices and present the component to the presentation station 775. The presentation robot 900 comprises a 4-axis servo robot, marketed by Adept Technology, Inc., Sunnyvale, California, as in the "Adept One" robot.

The system further comprises a printed circuit board locating and transfer system (the "BLT system") which automatically transfer the board into and out of the system work cell. The printed circuit board is precisely located at the insertion station 772 by the BLT system during the assembly cycle so that the board position is precisely registered with respect to the component insertion and clinching operations. In the disclosed embodiment, the board locating and transfer system comprises a printed circuit board conveyor system 750. The conveyor system is adapted to automatically convey the printed circuit board which is mounted on the conveyor into position to and from the insertion station 772.

The apparatus also includes a means for straightening the component leads and cutting them to a predetermined length. The lead straightening and cutting means comprises a pair of plates disposed at the presentation station, in combination with the presentation robot 900. In accordance with the invention the presentation robot 900 inserts the component leads into oversized lead openings formed in the straightener/cutter plates, and then oscillates the component body through a predetermined series of movements, bending the leads back and forth in a repetitive exercising motion so as to straighten the leads.

The presentation robot 900 then releases the component body, with its leads clamped in the lead straightening and cutting plates. At this point the component insertion robot 920 moves to the presentation station 775 and its end effector 922 grips the body of the component. If the leads are not to be cut, the lead clamp is released and the part is inserted. However, if the leads are to be cut, the lower plate is moved by a powerful shear cylinder to shear the leads.

The component is then inserted by the insertion robot system 920. In this embodiment, robot 920 comprises the Seiko robot system.

Another facet of this embodiment is to employ the clinching apparatus described hereinabove to clinch the leads of the components as they are inserted into the printed circuit board. Thus, as each part is inserted into the board, the clincher element is operated through a preprogrammed clinching movement to clinch its leads. The insertion robot then releases that component and returns to the next station.

For the embodiment shown in Fig. 12, the rectangular upper table surface 602 as described with respect to the clinching system embodiment shown in Fig. 2 is replaced by elements of the conveyor system.

Thus, the system described in Fig. 12 is a general purpose and flexible system adapted to efficiently select a part to be inserted, straighten and cut the leads, and then insert and subsequently clinch the leads to the printed circuit board. The system is highly flexible in that it is not limited to a single board application, but rather is programmable to accommodate a wide variety of printed circuit boards, components, and assembly operations. Moreover, no mechanical changes are required to shift from one type of board to another. So long as the required components are made available at the feeder devices, the system can accommodate different board products simply by modifying the system software. This is a substantial advantage over systems which require mechanical retooling to change over from one product to another.

Referring now to Fig. 14, a top view of the conveyor system 750 is illustrated. The conveyor comprises a pair of flexible chains comprising a plurality of linked chain elements which are reeved about idler and drive pulleys disposed along the longitudinal extent of the conveyor.

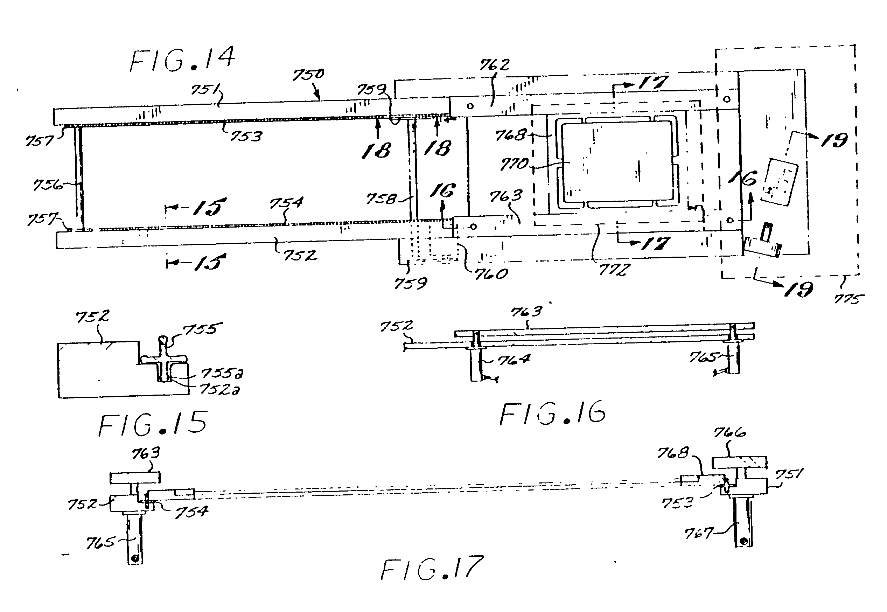

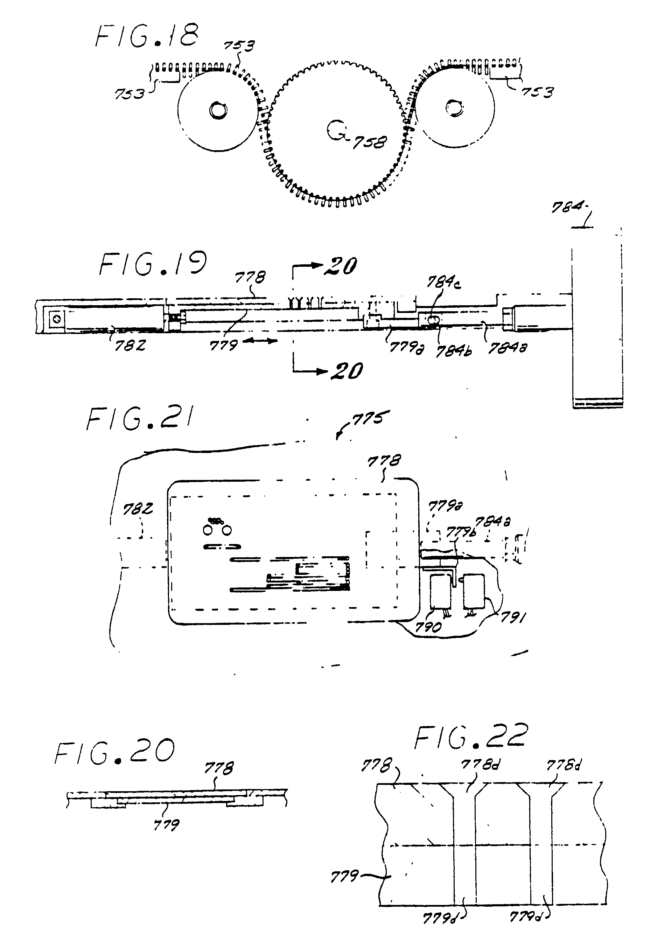

In the disclosed embodiment, the conveyor 750 comprises a pair of elongated side rails 751, 752 mounted in substantially parallel relationship. Each of the side rails 751, 752 comprises a channel whose width is adapted to receive an extending leg of the respective chain element. This is shown, for example, in Fig. 15, a cross-sectional view taken along line 25 - 25 of Fig. 14, wherein an element of chain 755 is shown with a leg member 755a disposed in a receiving channel 752a formed in the side rail 752. In the Figs. 14 and 18, idler shaft 756 and idler pulleys 757 and 757a, as well as drive shaft 758, drive pulley 759 and drive motor 760 are visible or shown in phantom.

The printed circuit boards 770 are received in a board bracket 768 for transport along the conveyor 750. The conveyor 750 is fitted with clamping means for clamping the board bracket 768 in fixed position. The clamping means is illustrated in Figs. 16 and 17. In the longitudinal cross-section of Fig. 16, the upper rail 763 is shown in relation to the elongated side rail 752. The upper rail 763 is mounted for vertical movement on shafts of the air cylinders 764 and 765. Thus, by actuation of the air cylinders 764, 765 the rail 763 may be moved vertically upwardly or downwardly so that in the downward position the board bracket is clamped between the adjacent surfaces of rails 752 and 763. Upper rail 762 is supported in a similar fashion by a corresponding pair of air cylinders.

In the horizontal cross-sectional view of Fig. 17, the bracket 768 is shown as it is supported between the two conveyor chains 754, 753. The upper rails 763, 766 are illustrated in the raised position with respect to the bracket 768. Thus, by actuation of the pairs of air cylinders supporting the upper rails 763, 766, these rails may be brought into clamping relationship so as to clamp the bracket 768 in a fixed position.

The component insertion station is generally indicated by phantom line 772 in Fig. 14. With the printed circuit board 770 held in bracket 768, which is in turn clamped in position by the rail clamp as described above, a clinching system such as has been described with respect to Figs. 2 - 11 may be constructed in relation to the insertion station 772. In this application, the table surface 620 of the previous embodiment is replaced with the conveyor system 750 and the bracket 768.

The component presentation station 775 (Fig. 24) receives the selected component from the presentation robot 900. At this station, the component leads are straightened and cut to a predetermined length. Referring now to Figs. 19 - 22, the elements at station 775 comprising the component lead straightener and cutting system are disclosed in simplified form.

The lead straightening and cutting system comprises a pair of plates operated in combination with the component presentation robot 900. Straightener plate 778 and shear plate 779 are arranged in a parallel, contiguous relationship. The lateral position of upper plate 778 is fixed. The thickness of straightener plate 778 determines the length of the component leads after the shearing operation. This thickness will depend on the particular application; in the disclosed embodiment, plate 778 has a thickness of 8 mm (3/16 inches).

A plurality of funnel-shaped openings are formed in the plates 778, 779, defining one or more opening patterns respectively corresponding to the component lead pattern of one or more components. The hole patterns employed in the preferred embodiment extend over a 50 by 100 mm (2 inch by 4 inch) rectangular area, to accommodate components as large as 50 by 100 mm (2 inches by 4 inches). There is formed in the plates 778, 779 a plurality of opening patterns which will collectively accommodate the various types of components to be inserted into the particular board, or into a plurality of board types. The system is programmed with information defining the respective position of each opening pattern, and the robot 900 is adapted to insert the respective component into the corresponding opening pattern.

The openings formed in straightening plate 778 are funnel-shaped, as illustrated in the cross-sectional view of Fig. 22. The size of the openings will depend on the diameters of the component leads to be inserted, and the component lead spacing. For components having in-line leads, the respective funnel openings may be arranged as series of tangential openings to maximize the ability to insert bent leads into the openings in the straightening plate. A typical opening size is 3 mm (.120 inches) at the top of the funnel opening in plate 778, and 1.7 mm (.067 inches) at the bottom of the funnel.

Shear plate 779 is mounted in a sliding relationship with respect to straightner plate 778.

The position of lower plate 779 in relation to plate 778 is determined by the opposing clamp and shear air cylinders 782 and 784. The air cylinders 782, 784 are secured to opposing ends of lower plate 779 in an axially aligned relationship, as shown in phantom in Fig. 21.

With the plates 778, 779 aligned so that the respective openings in each plate are aligned, the presentation robot is adapted to insert the component leads into the appropriate opening pattern in plates. Air cylinder 782 has a diameter of about 13 mm (1/2 inch), to which a supply of pressurized air at 700 kPa (100 psi) is selectively coupled through a valve (not shown), to exert a laterally clamping force, typically about 20 pounds on plate 779. The purpose of cylinder 782 is to clamp the leads in position by slightly moving the lower plate in relation to upper plate 778. The clamping force is not sufficient to shear the component leads.

The purpose of shear cylinder 784 is to exert a shearing force on the lower plate 779 so as to forcably move the lower plate 779 in relation to upper plate 778 so as to shear the component leads as they extend below the plate 778. In the disclosed embodiment, the air cylinder 784 has a diameter of 100 mm (4 inches) and a 3.2 mm (1/8 inch) stroke, and is coupled selectively to a 700 kPa (100 psi) air supply through an air valve (not shown) to exert 5340 N (1200 pounds) of cutting forces.

Shear cylinder 784 comprises shear arm 784a which is connected to a clevis 779a, secured to the plate 779. The pin 784c extends through slot 784b formed in arm 784a to secure the clevis 779a to the arm 784a. The slot allows free clamping movement of the lower plate 779 caused by actuation of air cylinder 782, without requiring the clamp cylinder 782 to exert enough force to move the shear cylinder 784.

A pair of microswitch sensors 790, 791 are appropriately arranged to be triggered by arm 779b mounted to the clevis 779a. Sensor 790 indicates that the plates are in the aligned position, and sensor 791 indicates the end-of-travel for the shear motion, providing a positive indication that the shear action has been performed.

The lead straightening and cutting system further comprises the presentation robot 900. The robot 900 employs an end effector 905, shown in Fig. 23, mounted on robot arm 901, to grip the components at the feeder devices. The end effector is adapted for a 45° pitch angle to accommodate gravity feeder tracks, and can be actuated to rotate 45° to squarely present the gripped component to the presentation station 775.

The end effector body member 906 is adapted to rotate about hinge pin 906a in response to the force executed by the air cylinders 907a, 906b. The air cylinders comprise arms 907c, 907d, which are secured to corresponding clevis members 906b,c formed on body member 906. The end effector components are cooperatively arranged so that the gripping fingers may be disposed at a 450 angle from the horizontal, or at the horizontal plane.

The end effector 905 comprises two pairs of fingers, an outer pair 905a, 905b, each formed with a respective protruding tang 905c, 905d, and an inner pair 905e, 905f.

The outer fingers 905a, 905b are each mounted for translation in directions normal to the plane of surface 905i, i.e., into and out of the plane defined by surface 905i. Each of fingers 905a, 905b is biased in the extended position illustrated in Fig. 23 by low pressure air cylinders (not shown).

The inner fingers 905e, 905f are arranged for translation toward and away from each other. Their movement is driven by pneumatic air cylinder means (not shown) and is synchronized such that each finger is driven inwardly or outwardly in synchronization with the other finger. The fingers 905e, 905f are arranged to exert a strong gripping force on the gripped components, greater than 220 N (50 pounds), to firmly grip the component for the lead straightening sequence.

The end effector 905 further comprises a hold-down pin 905g which is biased in the extended position shown in Fig. 23 by a spring or air cylinder (not shown) but which may be depressed inwardly. The end effector further comprises a microswitch sensor 905h mounted to indicate when the inner fingers have fully closed. The sensor 905h thus provides a signal that the fingers 905e, 905f have failed to grip a part, since the fingers do not go the fully closed position when a part has been gripped.

The operation of the end effector is more fully described with reference to Figs. 26(a) - (c). Fig. 26(a) illustrates a partial side view of a tube feeder 925, arranged at a 45° angle from the horizontal. A plurality of components 927 having in-line leads are stored in tube 927. The feeder 925 includes a central rib 925(d). The leads of the components 927 straddle central rib 925(d). A retainer pin 925(c) is passed through the end of rib 925d.

A novel aspect is the L-shaped spring clip 925a secured by fastener 925b to the body of feeder 925. The L-shaped clip 925a further includes a curved tang 925d, and the elongated side 925e forms a 90° angle with retainer portion 925f. While not visible in the side view, retainer portion 925f is about one third the length of side portion 925e.

The purpose of clip 925a is to provide a stop means preventing the leads of components 927 from colliding with pin 925c and thereby bending the leads. With the clip in the position shown in Fig. 26(a) the trailing or back edge of the first component is retained inside the tube, preventing the component from tumbling out of the feeder 925 as the components are loaded.

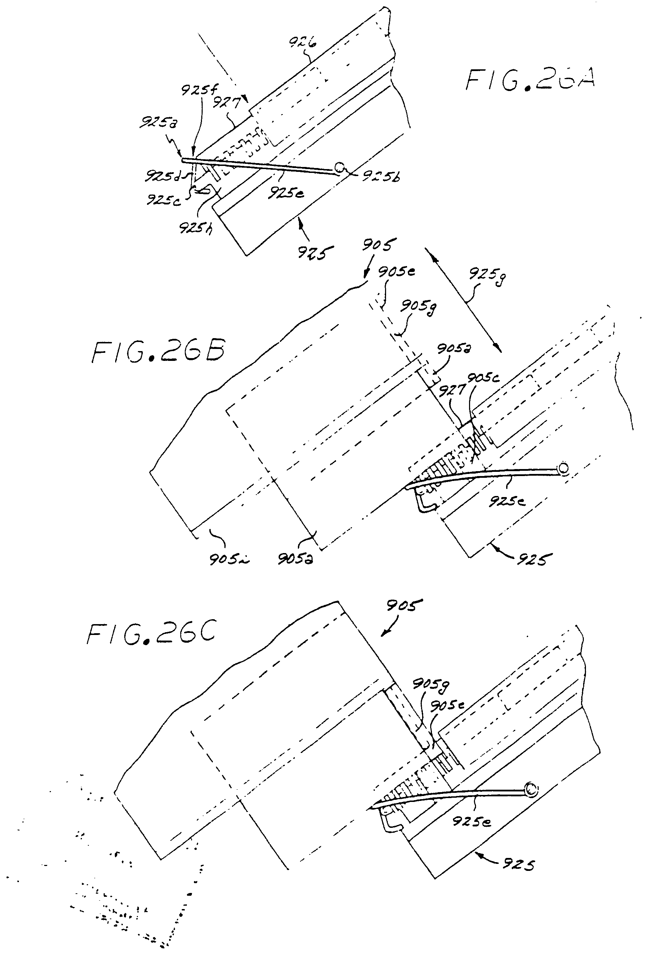

Referring now to Figs. 26 (b), (c), side views of the end effector 905 and the feeder 925 are shown, with Fig. 26(b) illustrating an initial contacting position as the end effector initially engages the feeder 925, and Fig. 26(c) illustrating a fully engaged position for extracting the component. The end effector is moved along axis 925g from the position of Fig. 26(b) to that of Fig. 26(c).

The outer finger 905a initially engages the clip 925a, and depresses it out of engagement with the body of component 927. Component 927 then slides down the central rib into engagement with pin 925c. As the effector approaches the feeder 925, the tang 905c engages the body of feeder 925, and as the effector 905 moves to the fully engaged position, the outer finger 905a slides inwardly into surface 905i, against the bias of its corresponding air cylinder.

In the fully engaged position of Fig. 26(c), the inner jaws 905e, 905f are in position to grip the component 972, the hold-down pin 905g having engaged the trailing edge of the component 927 to hold the component down into contact with central rib 925d, allowing the end effector 905 to squarely grip the component 927.

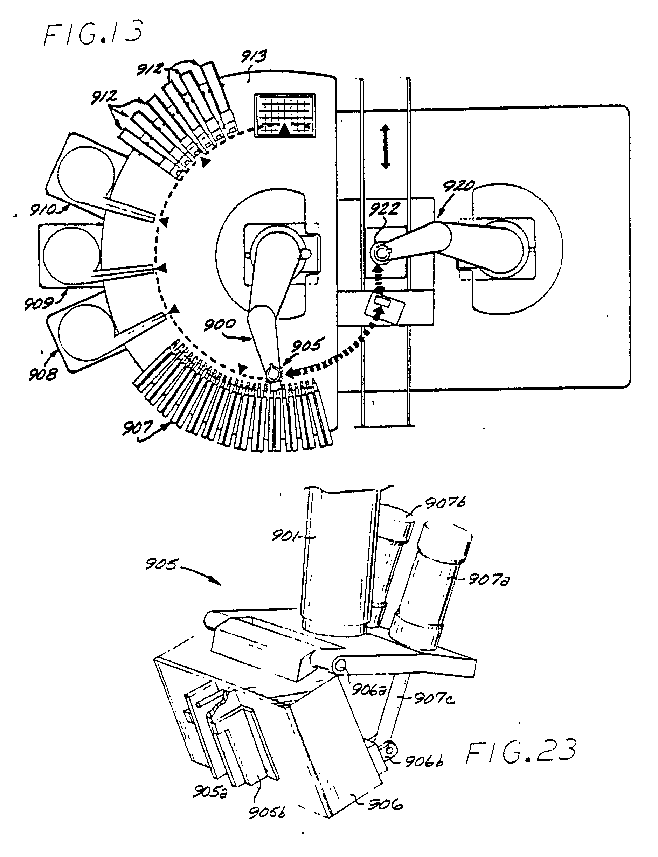

As shown in the top view of Fig. 13, the presentation robot 900 selects one component from the plurality of component feeders. The end effector 905 is adapted to securely grip the body of the selected component for the ensuing lead straightening sequence. In this sequence, the presentation robot moves to the presentation station 775, and inserts the component leads into the corresponding opening pattern in the plates 778, 779, which are in the aligned position. With the leads inserted in the funnel openings and their position substantially constrained, the presentation robot executes a predetermined series of oscillating movements moving the component body with respect to the constrained leads. The particular movements are typically empirically determined for each particular component type. A typical series of movements is to repetitively oscillate the component body in four directions +X, -X, +Y, -Y, 0.8 mm (1/32 inch) away from the central inserted position.

The oscillatory movements are adapted to flex the leads in one direction (for example, +X) to a minimum yield point, i.e., the deflection at which the lead no longer springs back or returns to its initial position, and then to flex the lead in the opposite direction (-X) from the central position to the opposite yield point. The yield point depends on factors such as the stiffness of the leads and is empirically determined. The leads may then be flexed in the direction (+Y, -Y) normal to the first series of movements. More than one series of movements may be required. Upon completion of the oscillatory movements, the leads will be aligned at averaged positions within a few thousandths of an inch (0.025 mm) from the nominal, perfectly aligned condition. It is desirable to minimize the required oscillations, to minimize the risk of breaking the leads.

An aspect of the invention is the flexibility of the system to accommodate virtually any component and straighten its leads sufficiently that the insertion robot can successfully insert the component into the circuit board. Because the funnel openings comprising the opening patterns in the plates 778, 779 are over-sized relative to the circuit board opening, the presentation robot is able to insert components into the plates 778, 779 which could not be successfully inserted into the circuit board by the insertion robot because one or more of the component leads are misaligned.

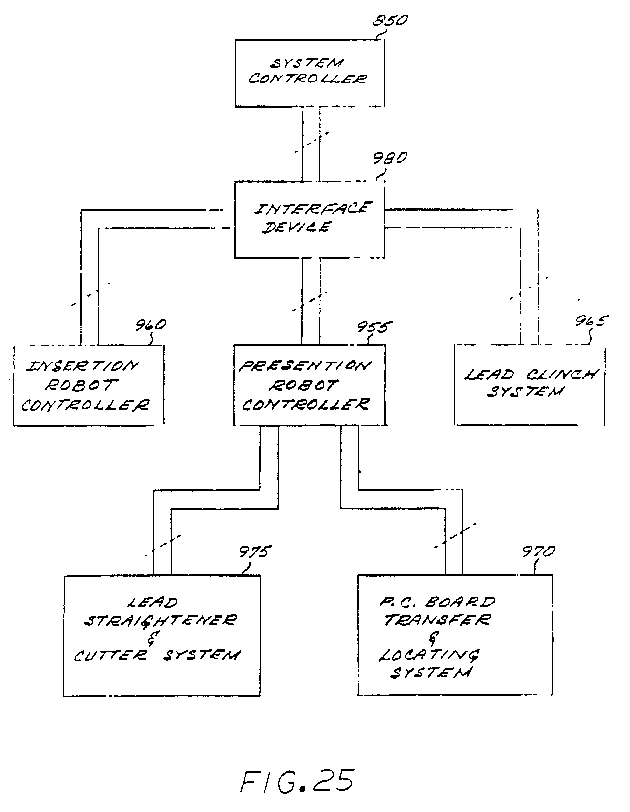

Fig. 25 is a block diagram illustrative of the control system for architecture controlling the operation of the component insertion system shown in the perspective view of Fig. 12. In this embodiment, the system controller 850 provides overall control over the entire system. As described above, controller 850 comprises a personal computer station, such as the IBM personal computer, with associated memory, display and keyboard functions, enabling a system operator to interface with the system.

In the embodiment, the presentation robot 900, as well as the insertion robot, comprise commercially available systems, and each system includes a robot controller, indicated in Fig. 25 as presentation robot controller 955 and insertion robot controller 960.

The system controller is interfaced with the presentation robot controller 955, the insertion robot controller 960 and the clinch system (indicated generally as block 965) through interface device 980. Each robot controller is programmed to accept instructions from the system controller 850, and to provide responsive information to the controller 850, via the interface device 980.

The component clinch system 965 is directly controlled by the system controller, as described above.

The board transfer and locating system, indicated generally in Fig. 25 as block 970, is controlled by the presentation robot controller 955. Thus, controller 955 is adapted to control the operation of the conveyor motor and the air cylinders actuating the clamp mechanism for fixing the location of the board bracket 768 at the insertion station 772.

The presentation robot controller 955 is further adapted to control the operation of the lead straightener and cutting system. Thus, the controller 955 controls the function of the clamp and shear cylinders, and monitors the sensors 790, 791. The controller 850 indirectly controls the operation of the presentation robot 900, by interfacing with the robot controller 955.

The system controller 850 is programmed to perform such functions as system start-up control, data handling, system sequencing, error fielding, and controlling the teaching sequences for the insertion robot and the clinch system.

The presentation robot controller 955 includes a peripheral disc drive memory unit, enabling the controller to perform several program functions. The controller 955 controls the movement of the presentation robot arm and end effector, in its part retrieval function. The controller 955 also controls the straightener and cutter operation sequence, and the handshaking performed with the insertion robot to ensure that the operations of the two robots are properly sequenced to avoid collisions.

The above functions are performed by one program for the controller. By another program, the controller 955 communicates with the system controller 850 and controls the operation of the board locating and transfer system. Another program is employed for the manual teaching sequence by which the pick up location and presentation location of each component are loaded into memory. Another program performs safety functions to provide for safe operation following emergency stop of the system, and verification that the position data which has been learned by the controller are regionally correct, i.e., not in conflict with the insertion module.

The insertion robot controller 960 is adapted to carry out a component pick-up and insertion function. The movement of the insertion robot arm and the operation of the end effector are under the control of controller 960. Other functions performed by this controller include part presence sensing, tactile insertion sensing, handshaking with the clinch system, teaching of the insertion movements and testing.

It is to be understood that the control system is provided with insertion program information for each type of board to be processed. The information defines the sequence by which the various components are to be inserted into the board and their respective board locations. The control system is further provided with information defining the location of each part feeder device and the appropriate component type provided at that feeder device.

The system controller 850 is adapted to coordinate the operation of the above-described components of the component insertion systems. A series of steps occurs in sequence. First, the BLT system is operated to convey a circuit board to the insertion station and clamp it in the insertion position. The presentation robot selects the first component from the appropriate feeder device and delivers it to the component presentation station, where the leads are straightened. The presentation robot then releases the component and moves away to select the next component.

The insertion robot then grips the first component at the presentation station and the leads may then be sheared. The insertion robot then inserts the component at its predetermined location on the board. While the insertion robot grips the component in its inserted position, the clinching element clinches predetermined leads of the component. The insertion robot then returns to the presentation station to grip the next component.

These steps are repeated until all the components on the board have been inserted. The BLT system then conveys the finished board away from the insertion station and delivers a new board to the station.

For the sake of clarity, specific details concerning the interfacing of the respective controllers 850, 955, 960 have been omitted. For similar reasons, specific details concerning air valves, motor drivers and peripheral devices for interfacing the controller 850 with the various elements of the board transfer and locating system 970 and the lead straightening and cutting system 975 are omitted. Such details will be apparent to those skilled in the art from the above description.

An improved component insertion system has been disclosed. The system provides the flexibility of adapting to insertion of different products without mechanical retooling, by changing the controller software. The system enhances the productivity of circuit board assembly lines by substantially reducing the time required to convert the line from assembly of one type of circuit board to another type. Moreover, because retooling is not required, the capital expenditures required to implement an assemble line capable of assembling a plurality of circuit board types may be reduced.

## Claims

1. Apparatus for active clinching of component leads after insertion thereof from an upper side of a circuit board (610) and through apertures in the board to extend from the lower surface thereof, thereby to secure the component in its inserted position, comprising a clinching element (650) for bending the leads, characterized by means (702, 723) for driving the clinching element (650) through a programmably determined path of travel adjacent the lower surface of the board in response to control signals, and in that the clinching element (650) effects the bending of a lead by running into the lead during the course of its programmably determined travel, and by a programmable controller (850) adapted to provide control signals to the drive means so as to pass the clinching element through a programmably determined sequence of movements such that the clinching element contacts and bend one or more leads of the component.

2. Apparatus according to claim 1, characterized in that the clinching element (650) comprises a rounded clinch tool whose size is proportioned in relation to the component lead size and spacing so as to provide the capability of clinching a single component lead during a clinch movement.

3. Apparatus according to claim 1 or 2, characterized by means (655) for positioning the clinching element (650) at a clinch position directly adjacent the lower surface for contacting and bending the leads, or at a retracted position well away from the lower surface, so as not to contact downwardly extending leads.

4. Apparatus according to claim 3, characterized in that the means (655) for positioning the clinching element (650) comprises means for extending and retracting this element along an axis extending substantially perpendicular to the lower surface of the circuit board, and in that positioning means is controlled by the programmable controller (850).

5. Apparatus according to claim 4, characterized in that the positioning means (655) comprises a cylinder and piston assembly, whereof the piston (655v) travels along the said axis and carries the clinching element (650).

6. Apparatus according to any of claims 1 to 5, characterized in that the drive means is adapted to programmably drive the clinch element (650) in lateral and longitudinal directions, and the drive means comprises a first drive means (702) for driving the clinch element in the lateral direction, and a second drive means (723) for driving the clinch element in the longitudinal direction.

7. Apparatus according to claim 6, characterized in that the said directions are in a plane which is substantially parallel to the lower side of the circuit board (610).

8. Apparatus according to claim 7, characterized in that drive means comprise an upper carriage assembly (670) supported for lateral movement by a lateral support element (680, 682) having first and second ends; first and second opposed longitudinal support elements (694, 696); first and second lower carriage assemblies (690, 692), the first and second ends of the lateral support element (680, 682) being mounted in the first and second lower assembly respectively; the first and second lower carriage assemblies being carried for longitudinal movement on the first and second longitudinal support elements respectively, the first drive means (702) driving the upper carriage assembly in the lateral direction along the lateral extent of the lateral support element; and the second drive means (703) driving the first and second lower assemblies in the longitudinal direction along the longitudinal extents of the longitudinal support elements.

9. Apparatus according to any of claims 1 to 8, further characterized by a programmable insertion robot (10) for inserting components in the circuit board (610) at an insertion station, and in that the programmable controller (850) controls the driving means (702, 703) in conjunction with the robot to clinch at least one lead of an inserted component while it is held by the robot at the insertion station.

10. Apparatus according to claim 9, further characterized by a component presentation station (70) and in that the robot (10) comprises means for sequentially gripping components presented at the presentation station and inserting such components into the circuit board (610) at the insertion station at predetermined locations.

11. Apparatus according to claim 9 or 10, further comprized by transport means (750) for transporting a circuit board to the insertion station and locating the circuit board at a predetermined location with respect to said insertion robot means.

12. Apparatus according to claim 11, characterized in that the transport means comprises a motor driven conveyor system (750) which is adapted to convey the circuit board to the insertion station in response to motor drive signals.

13. Apparatus according to claim 12, characterized in that the programmable controller (850) is a central controller adapted to control the operation of the transport means (750), the insertion robot (10) and the driving means (702, 703).

14. Apparatus according to claims 9 and 10, characterized by a plurality of component feeder devices (907 - 913) and a presentation robot (900) adapted to select and pick up components from the feeder devices and transfer them to the presentation station (775) for picking up by the insertion robot (10).

15. Apparatus according to claim 14, characterized by a lead straightening plate (778) at the presentation station (775) and having lead openings therein, and in that the presentation robot (900) is arranged to insert the leads of a component in such holes and then move the component through a sequence of oscillatory movements such as to repetitively exercise and substantially straighten the component leads.

16. Apparatus according to claim 15, further characterized by cutting means (779) for cutting the leads of the selected components to a predetermined length.

17. Apparatus according to claim 14, 15 or 16, characterized in that the feeder devices comprise a plurality of tube feeders (907), each for storing a plurality of components having in-line leads and presenting one of the stored components at a pickup location which is directly accessible by the presentation robot (900) independent of the other tube feeders.

18. Apparatus according to claim 17, characterized in that the tube feeders (907) are inclined to the horizontal to provide for gravity feeding of successive components therefrom, and each comprises a retaining means for retaining the next available component at the pickup location until the feeder device is accessed by the presentation robot (900).

19. Apparatus according to claim 18, characterized in that the presentation robot (900) comprises an end effector (905) having a pair of gripping jaws (905e, f) and means for controlling the attitude of the jaws relative to the horizontal to a first attitude aligned with a tube feeder (907) for gripping the components at the pickup location and to a second attitude aligned with the horizontal to deliver the components to the presentation station (775).

20. Apparatus according to any of claims 14 to 19, characterized in that the programmable controller (850) controls the presentation and insertion robots (900, 10) as well as the driving means (702, 703).

21. Apparatus according to claim 20, characterized in that the controller (850) comprises memory means for storing data representative of the components to be inserted into the circuit board, the sequence in which the components are to be inserted and the respective positions at which the components are to be inserted.

22. Apparatus according to claim 21, characterized in that the controller memory means is further adapted to store clinch data for the respective components to be inserted in said board, the clinch data including data defining the predetermined clinch system movement for each component.

23. Apparatus according to claim 21 or 22, characterized in that the memory means further store data indicative of the positions of the respective feeder devices.

24. Apparatus according to any of claims 1 to 23, characterized by tactile sensing means for detecting whether a lead has been successfully clinched and providing an output signal to the controller indicative of successful clinching.

25. A method of automatic insertion of components in circuit boards, comprising the steps of: securing the printed circuit board at an insertion station; programming a presentation robot to sequentially select predetermined components from a plurality of component feeder devices and present the selected components to a presentation station, and thereafter to release the component at the presentation station, programming an insertion robot to sequentially pick up the selected component at the presentation station in coordination with the presentation robot and thereafter inserting the selected component at a predetermined location in the board; and moving a clinching element through a programmed path such that the element runs into and bends at least one lead of an inserted component while the component is gripped by the insertion robot.

**Patentansprüche**

1. Einrichtung zum Umbiegen von Bauteilfüßen, nachdem diese von einer Oberseite einer Schaltungsplatte (610) aus durch Öffnungen in die Schaltungsplatte so eingesteckt worden sind, daß sie von deren Unterseite vorstehen, um dadurch das Bauteil in seiner eingesteckten Lage festzuhalten, mit einem Biegeelement (650) zum Umbiegen der Füße, dadurch gekennzeichnet, daß Einrichtungen (702, 723) vorgesehen sind, um das Biegeelement (650) über einen programmierbar festgelegten Verfahrweg an der Unterseite der Schaltungsplatte entsprechend Steuersignalen zu bewegen, daß das Biegeelement (650) das Umbiegen eines Fußes dadurch bewirkt, daß es während des Verlaufs seines programmierbar festgelegten Verfahrwegs gegen den Fuß fährt, und daß eine programmierbare Steuereinheit (80) vorgesehen ist, mittels welcher Steuersignale an die Antriebseinheit gegeben werden, damit das Biegeelement eine programmierbar festgelegte Bewegungsfolge durchläuft, so daß das Biegeelement ein oder mehrere Füße des Bauelements berührt und umbiegt.

2. Einrichtung nach Anspruch 1, dadurch gekennzeichnet, daß das Biegeelement (650) ein gerundetes Biegewerkzeug aufweist, dessen Größe hinsichtlich der Größe der Bauelementfüße und deren Abstand entsprechend bemessen ist, damit ein einzelner Bauelementfuß während einer Biegebewegung umgebogen wird.

3. Einrichtung nach Anspruch 1 oder 2, gekennzeichnet durch eine Einrichtung (655) zum Positionieren des Biegeelements (650) in einer Biegeposition unmittelbar an der Unterseite, um die Füße zu berühren und umzubiegen, oder in einer zurückgezogenen Position entsprechend weit weg von der unteren Fläche, um so nach unten vorstehende Füße nicht zu berühren.

4. Einrichtung nach Anspruch 3, dadurch gekennzeichnet, daß die Einrichtung (655) zum Positionieren des Biegeelements (650) eine Einrichtung zum Ausfahren und Zurückführen des Elements entlang einer Achse aufweist, die senkrecht zu der Unterseite der Schaltungsplatte verläuft, und daß die Positioniereinrichtung durch die programmierbare Steuereinheit (850) gesteuert ist.

5. Einrichtung nach Anspruch 4, dadurch gekennzeichnet, daß die Positioniereinrichtung (655) eine Zylinder-Kolben-Einheit aufweist, wobei der Kolben (655v) entlang der Achse hin- und herbewegt wird und das Biegeelement (650) trägt.

6. Einrichtung nach einem der Ansprüche 1 bis 5, dadurch gekennzeichnet, daß mittels der Antriebseinrichtung das Biegeelement (650) in Seiten- und Längsrichtung programmierbar angetrieben wird, und daß die Antriebseinrichtung eine erste Antriebseinheit (702) zum Bewegen des Biegeelements in der seitlichen Richtung und eine zweite Antriebseinrichtung (723) aufweist, um das Biegeelement in der Längsrichtung zu bewegen.

7. Einrichtung nach Anspruch 6, dadurch gekennzeichnet, daß die Richtungen in einer Ebene liegen, welche parallel zu der Unterseite der Schaltungsplatte (610) verläuft.

8. Einrichtung nach Anspruch 7, dadurch gekennzeichnet, daß die Antriebseinrichtung eine obere Wageneinheit (670), welche für eine seitliche Bewegung durch ein seitliches Trägerelement (680, 682) mit ersten und zweiten Enden getragen ist, erste und zweite einander gegenüberliegende längs verlaufende Trägerelemente (694, 696) und erste und zweite untere Wageneinheiten (690, 692) aufweist, wobei die ersten und zweiten Enden des seitlichen Trägerelements (680, 682) in den ersten bzw. zweiten unteren Wageneinheiten gehaltert sind, die ersten und zweiten unteren Wageneinheiten für eine Längsbewegung an den ersten bzw. zweiten längs verlaufenden Trägerelementen gehalten sind, die erste Antriebseinrichtung (702) die obere Wageneinheit in der seitlichen Richtung entlang der seitlichen Erstreckung des seitlichen Trägerelements bewegt, und die zweite Antriebseinrichtung (703) die ersten und zweiten unteren Wageneinheiten in der Längsrichtung entlang der Längserstreckung der längs verlaufenden Trägerelemente bewegt.

9. Einrichtung nach einem der Ansprüche 1 bis 8, dadurch gekennzeichnet, daß ein programmierbarer Einsetzroboter (10) zum Einstecken von Bauteilen in die Schaltungsplatte (610) in einer Einsetzstation vorgesehen ist, und daß die programmierbare Steuereinrichtung (850) die Antriebseinrichtung (702, 703) zusammen mit dem Roboter steuert, um zumindest einen Fuß eines eingesetzten Bauteils umzubiegen, während es von dem Roboter in der Einsetzstation gehalten ist.

10. Einrichtung nach Anspruch 9, dadurch gekennzeichnet, daß eine Bauteile-Bereitstellungsstation (70) vorgesehen ist, und daß der Roboter (10) eine Einrichtung aufweist, um in der Bereitstellungsstation bereit gestellte Bauteile nacheinander zu erfassen, und um derartige Bauteile in der Einsetzstation an vorherbestimmten Stellen in die Schaltungsplatte (610) einzusetzen.

11. Einrichtung nach Anspruch 9 oder 10, gekennzeichnet durch eine Transporteinrichtung (750), um eine Schaltungsplatte in der Einsetzstation zu transportieren, und um die Schaltungsplatte an einer vorherbestimmten Stelle bezüglich des Einsetzroboters festzulegen.

12. Einrichtung nach Anspruch 11, dadurch gekennzeichnet, daß die Transporteinrichtung ein motorgetriebenes Fördersystem (750) aufweist, mittels welchem die Schaltungsplatte in der Einsetzstation entsprechend Motoransteuersignalen befördert wird.

13. Einrichtung nach Anspruch 12, dadurch gekennzeichnet, daß die programmierbare Steuereinheit (850) eine zentrale Steuereinheit zum Steuern des Betriebs der Transporteinrichtung (750), des Einsetzroboters (10) und der Antriebseinheit (702, 703) aufweist.

14. Einrichtung nach den Ansprüchen 9 und 10, gekennzeichnet durch eine Anzahl Bauteile-Zuführvorrichtungen (907 bis 913) und durch einen Bereitstellungsroboter (900), mittels welchem Bauteile von den Zuführvorrichtungen ausgewählt und aufgenommen werden und diese der Bereitstellungsstation (775) zugeführt werden, um dort von dem Einsetzroboter (10) aufgenommen zu werden.

15. Einrichtung nach Anspruch 14, dadurch gekennzeichnet, daß eine Fuß-Geraderichtplatte (778) in der Bereitstellungsstation (775) mit Öffnungen zum Einführen der Füße vorgesehen ist, und daß mittels des Bereitstellungsroboters (900) die Füße eines Bauteils in diese Öffnungen eingesetzt werden, und daß dann das Bauelement über eine Folge von oszillierenden Bewegungen entsprechend bewegt wird, um wiederholt auf die Bauteilfüße einzuwirken und sie im wesentlichen geradezurichten.

16. Einrichtung nach Anspruch 15, gekennzeichnet durch eine Schneideinrichtung (779), um die Füße der ausgewählten Bauteile auf eine vorherbestimmte Länge zu schneiden.

17. Einrichtung nach einem der Ansprüche 14, 15 oder 16, dadurch gekennzeichnet, daß die Zuführeinrichtungen eine Anzahl rohrförmiger Zuführeinheiten (907) aufweisen, die jeweils eine Anzahl Bauteile mit entsprechend ausgerichteten Füßen aufbewahren und eines der aufbewahrten Bauteile unabhängig von den übrigen rohrförmigen Zuführeinheiten an einer Aufnahmestelle bereitstellen, welche für den Bereitstellungsroboter (900) unmittelbar zugänglich ist.

18. Einrichtung nach Anspruch 17, dadurch gekennzeichnet, daß die rohrförmigen Zuführreinheiten (907) bezüglich der Horizontalen schräg angeordnet sind, um durch Schwerkraft nacheinander Bauelemente zuzuführen, und daß jede Zuführeinheit eine Rückhalteeinrichtung aufweist, um das nächste zur Verfügung stehende Bauteil an der Aufnahmestelle zurückzuhalten, bis von dem Bereitstellungsroboter (900) Zugriff zu der Zuführeinheit erfolgt ist.

19. Einrichtung nach Anspruch 18, dadurch gekennzeichnet, daß der Bereitstellungsroboter (900) einen Endeffektor (905) mit einem Klemmbackenpaar (905e, f) und eine Einrichtung aufweist, um die Stellung der Klemmbacken bezüglich der Horizontalen in einer ersten Stellung, welche bezüglich einer rohrförmigen Zuführreinheit (907) ausgerichtet ist, um die Bauteile an der Aufnahmestelle zu ergreifen, und in einer zweiten Stellung zu steuern, welche bezüglich der Horizontalen ausgerichtet ist, um die Bauteile in der Bereitstellungsstation (775) zu übergeben.

20. Einrichtung nach einem der Ansprüche 14 bis 19, dadurch gekennzeichnet, daß die programmierbare Steuereinheit (850) die Bereitstellungs- und Einsetzroboter (900, 10) sowie die Antriebseinrichtungen (702, 703) steuert.

21. Einrichtung nach Anspruch 20, dadurch gekennzeichnet, daß die Steuereinheit (850) einen Speicher aufweist, um Daten, welche die in die Schaltungsplatte einzusetzenden Bauteile darstellen, die Folge, in welcher die Bauteile einzusetzen sind, und die jeweiligen Positionen zu speichern, an welchen die Bauteile einzusetzen sind.

22. Einrichtung nach Anspruch 21, dadurch gekennzeichnet, daß in dem Speicher Biegedaten für die jeweiligen, in die Schaltungsplatte einzusetzenden Bauteile gespeichert sind, wobei die Biegedaten Daten einschließen, welche die vorherbestimmte Biegebewegung für jedes Bauteil festlegen.

23. Einrichtung nach Anspruch 21 oder 22, dadurch gekennzeichnet, daß in dem Speicher Daten speicherbar sind, welche die Positionen der jeweiligen Zuführeinheiten anzeigen.

24. Einrichtung nach einem der Ansprüche 1 bis 23, gekennzeichnet durch eine Fühleinrichtung zum Fühlen, ob ein Fuß richtig umgebogen worden ist, und zum Abgeben eines Ausgangssignals an die Steuereinheit, welche das korrekte Umbiegen anzeigt.

25. Verfahren zum automatischen Einsetzen von Bauteilen in Schaltungsplatten, mit den Schritten: Festhalten der gedruckten Schaltungsplatte in einer Einsetzstation, Programmieren eines Bereitstellungsroboters, um nacheinander vorherbestimmte Bauteile von einer Anzahl Bauteile-Zuführeinheiten auszuwählen und die ausgewählten Bauteile in einer Bereitstellungsstation bereitzustellen, und um danach das Bauteil in der Bereitstellungsstation abzugeben, Programmieren eines Einsetzroboters, um nacheinander die ausgewählten Bauteile in der Bereitstellungsstation in Zusammenarbeit mit dem Bereitstellungsroboter aufzunehmen, und um danach das ausgewählte Bauteil an einer vorherbestimmten Stelle in die Schaltungsplatte einzusetzen, und Bewegen eines Biegeelements über einen programmierten Verfahrweg, so daß das Element zumindest gegen einen Fuß eines eingesetzten Bauteils stößt und diesen umbiegt, während das Bauteil von dem Einsetzroboter gehalten ist.

## Revendications

1. Appareil pour l'accrochage actif de conducteurs de composants après leur insertion à partir d'une face supérieure d'une carte de circuit (610) et à travers des trous de la carte de manière à ce qu'ils fassent saillie par rapport à la surface inférieure de la carte, afin de fixer le composant dans sa position insérée, comprenant un élément d'accrochage (650) pour plier les conducteurs, caractérisé par des moyens d'entraînement (702, 723) de l'élément d'accrochage (650) suivant une trajectoire déterminée de façon programmable et adjacente à la surface inférieure de la carte en réponse à des signaux de commande, et en ce que l'élément d'accrochage (650) effectue le pliage d'un conducteur par impact sur le conducteur pendant le cours de sa trajectoire déterminée de façon programmable, et par un dispositif de commande programmable (850) prévu pour fournir des signaux de commande aux moyens d'entraînement afin que l'élément d'accrochage effectue une séquence de mouvements déterminée de façon programmable de sorte que l'élément d'accrochage rencontre et plie un ou plusieurs conducteurs du composant.

2. Appareil suivant la revendication 1, caractérisé en ce que l'élément d'accrochage (650) comprend un outil d'accrochage arrondi dont la dimension est déterminée par portion de la dimension et de l'espacement des conducteurs du composant de façon à donner la possibilité d'accrocher un seul conducteur de composant pendant un mouvement d'accrochage.

3. Appareil suivant la revendication 1 ou 2, caractérisé par des moyens (655) de positionnement de l'élément d'accrochage (650) à une position d'accrochage directement adjacente à la surface inférieure, pour venir en contact avec les conducteurs et les plier, ou à une position rétractée nettement éloignée de la surface inférieure, de façon à ne pas venir en contact avec les conducteurs s'étendant vers le bas.

4. Appareil suivant la revendication 3, caractérisé en ce que les moyens (655) de positionnement de l'élément d'accrochage (650) comprennent des moyens d'extension et de rétraction de cet élément le long d'un axe sensiblement perpendiculaire à la surface inférieure de la carte de circuit, et en ce que les moyens de positionnement sont commandés par le dispositif de commande programmable (850).

5. Appareil suivant la revendication 4, caractérisé en ce que les moyens de positionnement (655) comprennent un groupe à cylindre et piston, dont le piston (655v) se déplace le long dudit axe et porte l'élément d'accrochage (650).

6. Appareil suivant l'une quelconque des revendications 1 à 5, caractérisé en ce que les moyens d'entraînement sont prévus pour entraîner de façon programmable l'élément d'accrochage (650) dans les directions latérale et longitudinale, et les moyens d'entraînement comprennent un premier dispositif d'entraînement (702) pour entraîner l'élément d'accrochage dans la direction latérale, et un deuxième dispositif d'entraînement (723) pour entraîner l'élément d'accrochage dans la direction longitudinale.

7. Appareil suivant la revendication 6, caractérisé en ce que lesdites directions sont dans un plan qui est sensiblement parallèle à la face inférieure de la carte de circuit (610).

8. Appareil suivant la revendication 7, caractérisé en ce que les moyens d'entraînement comprennent un chariot supérieur (670) supporté pour un mouvement latéral par un élément support latéral (680, 682) présentant une première et une deuxième extrémités; un premier et un deuxième éléments supports longitudinaux opposés (694, 696); un premier et un deuxième chariots inférieurs (690, 692), les première et deuxième extrémités de l'élément support latéral (680, 682) étant montées dans le premier et le deuxième chariots inférieurs respectivement; les premier et deuxième chariots inférieurs étant portés pour un mouvement longitudinal sur les premier et deuxième éléments supports longitudinaux respectivement, le premier dispositif d'entraînement (702) entraînant le chariot supérieur dans la direction latérale sur l'étendue latérale de l'élément support latéral et le deuxième dispositif d'entraînement (703) entraînant les premier et deuxième chariots inférieurs dans la direction longitudinale sur les étendues longitudinales des éléments supports longitudinaux.

9. Appareil suivant l'une quelconque des revendications 1 à 8, caractérisé en outre par un robot d'insertion programmable (10) pour insérer les composants dans la carte de circuit (610) à une station d'insertion, et en ce que le dispositif de commande programmable (850) commande les dispositifs d'entraînement (702, 703) en conjonction avec le robot de manière à accrocher au moins un conducteur d'un composant inséré pendant que celui-ci est tenu par le robot à la station d'insertion.

10. Appareil suivant la revendication 9, caractérisé en outre par une station (70) de présentation de composant et en ce que le robot (10) comprend des moyens pour saisir séquentiellement les composants présentés à la station de présentation et insérer ces composants dans la carte de circuit (610) à la station d'insertion, à des endroits prédéterminés.

11. Appareil suivant la revendication 9 ou 10, comprenant en outre des moyens de transport (750) pour transporter une carte de circuit à la station d'insertion et placer la carte de circuit à une position prédéterminée par rapport audit robot d'insertion.

12. Appareil suivant la revendication 11, caractérisé en ce que les moyens de transport comprennent un système de convoyeur (750) entraîné par moteur, qui est prévu pour amener la carte de circuit à la station d'insertion en réponse à des signaux d'excitation du moteur.

13. Appareil suivant la revendication 12, caractérisé en ce que le dispositif de commande programmable (850) est un dispositif de commande centralisée prévu pour commander le fonctionnement des moyens de transport (750), du robot d'insertion (10) et des moyens d'entraînement (702, 703).

14. Appareil suivant les revendications 9 et 10, caractérisé par une pluralité de dispositifs de distribution de composants (907 - 913) et un robot de présentation (900) prévu pour choisir et prendre des composants à partir des dispositifs de distribution et pour les transférer à la station de présentation (775) afin qu'ils soient saisis par le robot d'insertion (10).

15. Appareil suivant la revendication 14, caractérisé par une plaque (778) de redressement de conducteur située à la station de présentation (775) et comportant des trous de passage de conducteur, et en ce que le robot de présentation (900) est prévu pour insérer ces conducteurs d'un composant dans ces trous puis pour communiquer au composant une séquence de mouvements d'oscillation de façon à solliciter répétitivement et à redresser sensiblement les conducteurs du composant.

16. Appareil suivant la revendication 15, caractérisé en outre par des moyens de coupe (779) pour couper les conducteurs des composants choisis à une longueur prédéterminée.

17. Appareil suivant la revendication 14, 15 ou 16, caractérisé en ce que les dispositifs de distribution comprennent une pluralité de distributeurs tubulaires (907), chacun pour stocker une pluralité de composants ayant des conducteurs en ligne et pour présenter l'un des composants stockés à une position de prise qui est directement accessible par le robot de présentation (900) indépendamment des autres distributeurs tubulaires.

18. Appareil suivant la revendication 17, caractérisé en ce que les distributeurs tubulaires (907) sont inclinés par rapport à l'horizontale pour assurer la distribution par gravité de leurs composants successifs, et chaque distributeur comprend des moyens de retenue pour retenir le composant disponible suivant à la position de prise jusqu'à ce que le dispositif de distribution soit accédé par le robot de présentation (900).

19. Appareil suivant la revendication 18, caractérisé en ce que le robot de présentation (900) comprend un organe actif d'extrémité (905) comportant une paire de mâchoires de prise (905e, f) et des moyens de commande de l'attitude des mâchoires par rapport à l'horizontale, à une première attitude alignée avec un distributeur tubulaire (907) pour saisir les composants à la position de prise, et à une deuxième attitude alignée avec l'horizontale pour distribuer les composants à la station de présentation (775).

20. Appareil suivant l'une quelconque des revendications 14 à 19, caractérisé en ce que le dispositif de commande programmable (850) commande les robots de présentation et d'insertion (900, 10) ainsi que les moyens d'entraînement (702, 703).

21. Appareil suivant la revendication 20, caractérisé en ce que le dispositif de commande (850) comprend une mémoire pour stocker des données représentatives des composants à insérer dans la carte de circuit, de la séquence suivant laquelle les composants doivent être insérés, et des positions respectives auxquelles les composants doivent être insérés.

22. Appareil suivant la revendication 21, caractérisé en ce que la mémoire du dispositif de commande est en outre prévue pour stocker des données d'accrochage pour les composants respectifs à insérer dans ladite carte, les données d'accrochage comprenant des données qui définissent le mouvement prédéterminé du système d'accrochage pour chaque composant.

23. Appareil suivant la revendication 21 ou 22, caractérisé en ce que la mémoire stocke en outre des données indicatives des positions des dispositifs de distribution respectifs.

24. Appareil suivant l'une quelconque des revendications 1 à 23, caractérisé par des moyens de détection tactile pour détecter si un conducteur a été accroché avec succès et pour fournir un signal de sortie au dispositif de commande, indicatif de l'accrochage réussi.

25. Procédé d'insertion automatique de composants dans des cartes de circuit, comprenant les opérations de: fixation de la carte de circuit imprimé, à une station d'insertion; programmation d'un robot de présentation pour choisir séquentiellement des composants prédéterminés à partir d'une pluralité de dispositifs de distribution de composants et pour présenter les composants choisis à une station de présentation; et pour libérer ensuite le composant à la station de présentation programmation d'un robot d'insertion pour saisir séquentiellement le composant choisi à la station de présentation, en coordination avec le robot de présentation, et pour insérer ensuite le composant choisi à une position prédéterminée dans la carte et déplacement d'un élément d'accrochage suivant un chemin programmé de sorte que l'élément rencontre et plie au moins un conducteur d'un composant inséré pendant que le composant est saisi par le robot d'insertion.

FIG.1

EP 0 204 451 B1

FIG.2

FIG.3

FIG.4

3

FIG.5

FIG.6

FIG.7

FIG.8

FIG.9

FIG.10

RELAY

FIG.11

FIG.12

EP 0 204 451 B1

FIG.13

912

912

913

9103

909

908

900

905

920

922

907

FIG.23

905

901

9076

907a

906a

907c

906b

905a

905b

906

FIG.14

FIG.15

FIG.16

FIG.17

EP 0 204 451 B1

FIG.18

FIG.19

FIG.21

FIG.20

FIG.22

FIG. 24

FIG.25

FIG.26A

FIG.26B

FIG.26C